(19)

Europäisches
Patentamt
European
Patent Office
Office européen
des brevets

(11)     EP 4 484 226 A1

(12)                    EUROPEAN PATENT APPLICATION

(43) Date of publication:
01.01.2025   Bulletin 2025/01

(21) Application number: 23306078.9

(22) Date of filing: 30.06.2023

(51) International Patent Classification (IPC):
B60R 21/017 $^{(2006.01)}$       H02J 7/34 $^{(2006.01)}$

(52) Cooperative Patent Classification (CPC):
B60R 21/0173; H02J 7/0047; H02J 7/345

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: NXP USA, Inc.
Austin TX 78735 (US)

(72) Inventors:
• Lounis, Nesrine Myriem
31023 Toulouse Cedex 1 (FR)

• Cassagnes, Thierry Dominique Yves
31023 Toulouse Cedex 1 (FR)
• Pennisi, Orazio
5656 AG Eindhoven (NL)
• Vedelago, Juliette Angèle
31023 Toulouse Cedex 1 (FR)

(74) Representative: Schmütz, Christian Klaus
Johannes
NXP Semiconductors Germany GmbH
Intellectual Property Group
Beiersdorfstr. 12
22529 Hamburg (DE)

(54)     DEVICE, SYSTEM AND METHOD

(57)     The present invention relates to a device, which is configured to control a circuit arrangement, connected to an energy storage device, such that a predefined measurement current is caused to flow through the circuit arrangement and the energy storage device. The device may detect voltage values of the energy storage device at different times, while the measurement current is flowing, such that a healthy message of the energy storage device can be generated based on the detected voltages. The present invention also relates to a corresponding system and method.

Fig. 1

EP 4 484 226 A1

**Description**

TECHNICAL FIELD

The present disclosure relates to device for controlling a circuit arrangement. The present disclosure also relates to a corresponding system and method.

BACKGROUND

Vehicle passenger protection systems, also known as vehicle safety systems, usually comprise airbags arranged in various frontal and side locations of the passenger seating positions of the vehicle. Airbags consist of a flexible envelope which is designed to inflate rapidly through pyrotechnic means during a crash of the vehicle, in order to prevent passengers from being severely injured.

A typical airbag system includes proximity and impact sensors (which detect when an accident situation is going to occur), ignition units, and a control unit which may include a microprocessor or a microcontroller. During an accident situation, the control unit may control an ignition unit of the airbag system such that the ignition unit ignites pyrotechnic material (of the ignition unit) to inflate the envelope of the corresponding airbag system.

For safety reasons, it cannot be assumed that, in an accident situation, the power source of the vehicle, i.e., the main battery, remains active during the crash. Also, the wiring harness of the vehicle may be damaged so that the airbag system may be disconnected from this power source. Therefore, airbag systems generally include an energy storage device with a reservoir capacitor which is intended to store sufficient energy so as to supply a current allowing to heat each ignition unit of the airbag system instead of the main battery whenever necessary. Thus, the airbag system may rely on the energy storage device to operate during crash situations without any supply from the main battery of the vehicle.

Nowadays, many vehicles are equipped with an electronic drive. The electronic drive requires the main battery to have a high capacity, where the main battery provides the electronic power for the electronic drive. Vehicle safety systems for vehicles with electronic drive usually include an interruption system that breaks an electrical connection between the main battery and the electronic drive when a vehicle accident occurs. The interruption system often includes another separate energy device energy with a reservoir capacitor. The interruption system often also includes an ignition unit and a control unit. During an accident situation, the control unit may control ignition unit of the interruption system such that the ignition unit ignites pyrotechnic material (of the ignition unit) to break and safely interrupt the electronic connection between the main battery and the electronic drive of the vehicle. Thus, the interruption system may also rely on the energy storage device to operate during crash situations without supply form the main battery of the vehicle.

It is desirable to diagnose the state of charge and/or health status of an energy storage device in order to validate that enough energy is available for firing and ensuring deployment of all airbags and/or for interruption an electronic connection between the main battery and the electronic drive.

SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

Aspects of the disclosure are defined in the accompanying claims.

In accordance with a first aspect of the present disclosure, a device for coupling to a circuit arrangement provided, where in the circuit arrangement extends from a first node to a second node, wherein an energy storage device is coupled to the first node, the circuit arrangement comprising a first, controllable semiconductor switch and a unit, referred to as an ignition unit, the first semiconductor switch and the ignition unit being connected in series, the ignition unit being configured to ignite upon reaching a predefined current flowing through the ignition units, referred to as an ignition current, and wherein the device comprises a control unit configured to be coupled to the first semiconductor switch, and wherein, in a first state, the control unit is configured to control the first semiconductor switch such that the first semiconductor switch adjusts an electrical current through the first semiconductor switch and the ignition unit to a predefined current referred to as a measurement current, wherein the measurement current is between 1% and 40% of the ignition current.

In one or more embodiments, the device comprises a sensor unit, wherein an input of the sensor unit, referred to as a sensor input, is configured to be coupled to the circuit arrangement and to detect a voltage, referred to as a detection voltage, representing an electrical voltage of the energy storage device, wherein the sensor unit is configured to generate an output voltage at an output of the sensor unit, referred to as sensor output, based on the detection voltage such that the output voltage also represents the voltage of the energy storage device, and wherein the control unit is coupled to the sensor output and configured, in the first state, to detect a first value of the output voltage at a first time, referred to as the first sampling time, and to detect a second value of the output voltage at a second time, referred to as the second sampling time.

In one or more embodiments, the control unit is configured to determine an electrical capacitance and/or an internal electrical impedance of the energy storage device based on the measured values.

In one or more embodiments, the circuit arrangement further comprises a second semiconductor switch, wherein the first semiconductor switch, the ignition unit, and the second semiconductor switch are connected in series, wherein the control unit is configured to be further coupled to the second semiconductor switch and wherein, in the first state, the control unit is configured to control the first and second semiconductor switches such that the first and second semiconductor switches adjust an electrical current through the first semiconductor switch, the ignition unit, and the second semiconductor switch to the predefined measurement current.

In one or more embodiments, the sensor input of the sensor unit is configured to be coupled to the first node of the circuit arrangement.

In one or more embodiments, the device comprises an electrical capacitor referred to as a decoupling capacitor, and wherein the device is configured to couple the sensor input of the sensor unit to the circuit arrangement via the decoupling capacitor.

In one or more embodiments, the sensor unit comprises an amplifier coupled between the sensor input and the sensor output.

In one or more embodiments, the sensor unit comprises an electrical capacitor, referred to as a feedback capacitor, coupled between the sensor input of the sensor unit and the sensor output of the sensor unit, wherein a capacitance of the feedback capacitor is between 5% and 66% of a capacitance of the decoupling capacitor.

In one or more embodiments, the control unit is configured to change from a first state of the control unit to a second state of the control unit, and vice versa.

In one or more embodiments, the circuit arrangement further comprises a third semiconductor switch, wherein the third semiconductor switch, the first semiconductor switch, the ignition unit, and the second semiconductor switch are connected in series, wherein the control unit is further configured to be coupled to the third semiconductor switch, wherein the control unit is configured to close the third semiconductor switch in the first state, and wherein the control unit is configured to open the third semiconductor switch in the second state.

In one or more embodiments, the sensor unit comprises a fourth semiconductor switch (S4) coupled between the sensor input of the sensor unit and the sensor output of the sensor unit, wherein the control unit is further coupled to the fourth semiconductor switch, wherein the control unit is configured, in the second state, to control the fourth semiconductor switch such that the fourth semiconductor switch is closed prior to the first sampling time and during a predefined time, referred to as the first closing time, wherein the control unit is configured to control the fourth semiconductor switch so that the fourth semiconductor switch is opened during a time referred to as the first opening time and directly following the first closing time, wherein the control unit is configured to change to the first state during the first opening time at a time referred to as the first switch time, and wherein the first sampling time follows the first switch time at a time interval of less than a predefined time, referred to as the first delay time.

In one or more embodiments, the control unit, in the first state, is configured to control the fourth semiconductor switch to be closed during a predefined time referred to as the second closing time directly following the first opening time, wherein the control unit is configured in the first state to control the fourth semiconductor switch so that the fourth semiconductor switch is opened during a predefined time referred to as the second opening time and directly following the second closing time, and wherein the second sampling time follows a start of the second opening time at a time interval of less than a predefined time referred to as the second delay time.

In one or more embodiments, the control unit is configured to detect a third value of the output voltage in the first state of the control unit at a third time referred to as the third sampling time, wherein the third sampling time is at a time interval of less than a predefined time, referred to as a lead time, before an end of the second opening time.

According to a second aspect of the present disclosure, a system is provided, wherein the system comprising: the device according to any of the preceding claims, the circuit arrangement, and the energy storage device, wherein the circuit arrangement extending from the first node to the second node, wherein the energy storage device being coupled to the first node, wherein the circuit arrangement comprises the first controllable semiconductor switch and the ignition unit, wherein the first semiconductor switch and the ignition unit are coupled in series, wherein the ignition unit is configured to ignite upon reaching a predefined current flowing through the ignition unit, referred to as an ignition current, and wherein the control unit of the device is coupled to the first semiconductor switch.

According to a third aspect of the present disclosure, a method for a device is provided, wherein the device can be coupled to a circuit arrangement extending from a first node to a second node, wherein an energy storage device is coupled to the first node, wherein the circuit arrangement comprises a first controllable semiconductor switch and a unit referred to as an ignition unit, wherein the first semiconductor switch and the ignition unit are connected in series, wherein the ignition unit is configured to ignite upon reaching a predefined current flowing through the ignition unit, referred to as ignition current, and wherein the device comprises a control unit configured to be coupled to the first semiconductor switch, and wherein the method comprises the step of: Controlling the first semiconductor switch by the control unit in a first state such that the first semiconductor switch adjusts an electrical current through the first semiconductor switch and the ignition unit to a predefined current referred to as a measurement current, wherein the measurement current is between 1% and 40% of the ignition current.

In accordance with a fourth aspect of the present disclosure, a computer program is provided, comprising executable instructions which, when executed by a processing unit, cause the processing unit being configured to carry out the method of the third aspect and/or one or more embodiments thereof.

DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:

Figures 1 and 7 each show a simplified block diagram of an embodiment of the device.

Figures 2 to 6 show a simplified signal charts.

Figure 8 shows a simplified flow chart of the method.

DESCRIPTION OF EMBODIMENTS

Because the illustrated embodiments of the present disclosure may for the most part be implemented using electronic components and circuits known to those skilled in the art, details will not be explained in any greater extent for the understanding and appreciation of the underlying concepts of the present disclosure and in order not to obfuscate or distract from the present disclosure.

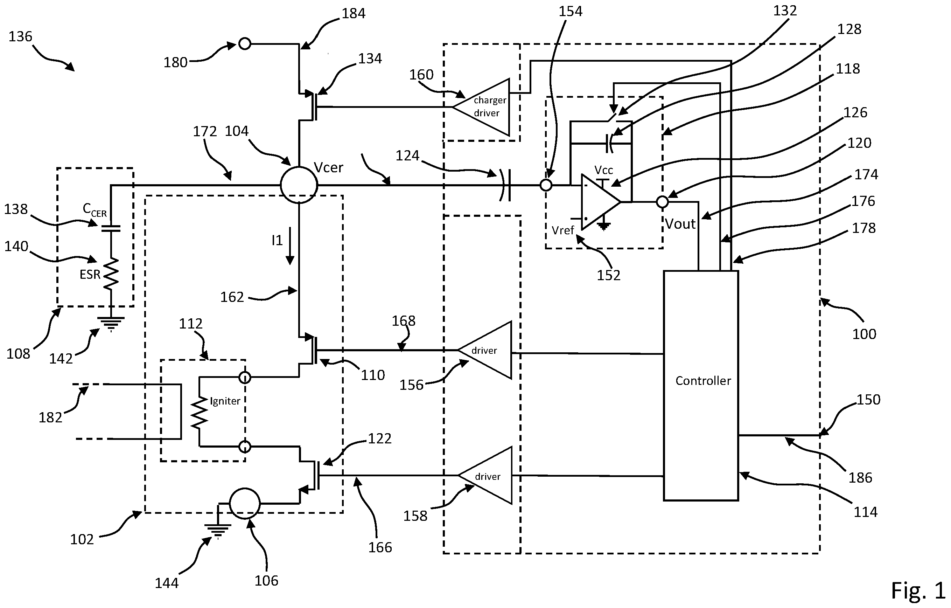

Figure 1 schematically illustrates a simplified system 136 comprising a device 100, a circuit arrangement 102, and an energy storage device 108. The circuit arrangement 102 preferably comprises an ignition unit 112. The ignition unit 112 can be attached to and/or arranged next to a signal connection 182, which can be part of a main battery of a vehicle. As a result, the ignition unit 112 may also form a part of the main battery. During an accident situation of the vehicle, a control unit 114 of the device 100 may control the circuit arrangement 102 such that the ignition unit 112 ignites pyrotechnic material (of the ignition unit 112) to interrupt the signal connection 182. The signal connection 182 may be a signal connection 182 to connect the main battery of the vehicle with an electronic drive of the vehicle and/or a signal connection between two cell packs of the main battery. The ignition unit 112 may rely on the energy storage device 108 to operate during the accident situation possibly without any supply from the main battery of the vehicle.

The circuit arrangement 102 extends from a first node 104 to a second node 106. The first node 104 may be configured to be coupled to another node, referred to as the fifth node 180, via a signal connection 184. A semiconductor switch 134, referred to as the fifth semiconductor switch 134, may be integrated into the signal connection 184. The fifth node 180 may be coupled to a power source (not shown), such as the (main) battery of a vehicle, such that a first voltage potential, in particular a first electrical voltage potential of the (main) battery, is present at the fifth node 180. The second node 106 of the circuit arrangement 102 may be configured to be coupled to the power source (not shown), such as the (main) battery of the vehicle, such that a second electrical voltage potential, in particular a second voltage potential 144 of the (main) battery, is present at the second node 106. The fifth semiconductor switch 134 may be controlled so that the fifth semiconductor switch 134 changes from a state, also referred to as the open state, to another state, referred to as the closed state, and vice versa. In the closed state of the semiconductor switch 134, an electrically conductive connection may be established between the fifth node 180 and the first node 104 of the circuit arrangement 102. In the open state of the semiconductor switch 134, the signal connection 184 is interrupted, so that there is no electrically conductive connection between the fifth node 180 and the first node 104. In an example, the control unit 114 may be configured to control the fifth semiconductor switch 134, such that the fifth semiconductor switch 134 is in the open state. For example, the once the control unit 114 changes to the first state Z1, the control unit 114 may control the fifth semiconductor switch 134 to change to the open state as well. The fifth semiconductor switch 134 will remain in the open state at least as long as the control unit 114 is in the first state Z1. In the second state Z2 of the control unit 114 and/or in another state (but not state Z1) of the control unit 114, the control unit 114 may control the fifth semiconductor switch 134 to change to the closed state.

The circuit arrangement 102 comprises a first semiconductor switch 110 and a unit 112, referred to as the ignition unit 112. The first semiconductor switch 110 and the ignition unit 112 may be integrated into a signal connection 162 of the first circuit arrangement 102, the signal connection 162 extending from the first node 104 to the second node 106. The first semiconductor switch 110 and the ignition unit 112 are connected in series. In an example, the first semiconductor switch 110 is configured as a controllable semiconductor switch 134. In an example, the first semiconductor switch 110 may be formed by a MOS transistor, such as an NMOS transistor or a PMOS transistor. In an example, the first semiconductor switch 110 may be controlled to be in an open state. In the open state, the first semiconductor switch 134 interrupts the series connection and/or the signal connection 162. The first semiconductor switch 134 may further be controlled to change from the open state to a closed state. In the closed state, the interruption is removed from where the first semiconductor switch 110 is integrated into the signal connection 162. In an example, the semiconductor switch 134 is configured as a controllable transistor such that the semiconductor switch 134 may be set in a (further) state, referred to as the control state, which may be understood as a state is between the open state and the close state. The semiconductor switch 110 may be configured, in particular in the control state, such that an electrical resistance of the semiconductor switch 110 is controllable. The electrical resistance of the first semiconductor switch 110 may relate to the electrical resistance of the semiconductor switch 110 that acts as an electrical resistance in the series circuit and/or an electrical resistance in the signal connection 162. The controllable electrical resistance of the first semiconductor switch may also be referred to as the measurement resistance of the first semiconductor switch 110.

The ignition unit 112 may comprise a component that heats up if an electric current flows through the ignition unit 112. The current flowing through the ignition unit 112 also flows through the associated component. The component becomes warmer the greater the current flowing through the ignition unit 112. In an example, the component is formed by a wire referred to as the heating wire, which heats up if electric current flows through the heating wire. In an example, the ignition unit 112 may further comprise pyrotechnic material that may be ignited by the heating wire if the heating wire reaches a predefined temperature referred to as the ignition temperature. In an example, the heating wire reaches the ignition temperature if a predefined current, also referred to as the ignition current, flows through the heating wire and/or the ignition unit 112. In an example, if a current flows through the ignition unit 112 that is equal to or greater than the value of the ignition current, then the heating wire will reach at least the ignition temperature. By reaching the ignition temperature, the heating wire will ignite the pyrotechnic material. Igniting the pyrotechnic material causes an exothermic reaction. In an example, an explosion of the pyrotechnic material may occur caused by the ignition. The ignition and explosion of the pyrotechnic material may serve to interrupt the signal connection 182. The ignition unit 112 may be used as a safety feature for a vehicle. If an accident of the vehicle occurs, the signal connection 182 may be interrupted via the ignition unit 112. In particular, the interruption of the signal connection 182 may be useful or necessary if the signal connection 182 connects the main battery to the vehicle's electrical drive train. However, the ignition unit 112 may also and/or alternatively be applied to other parts of the vehicle, such as for an airbag system. For the airbag system, the ignition unit 112 may be used to inflate a balloon of the airbag system by the exothermic reaction.

The control unit 114 may be controlled by a higher-level control unit of the vehicle to be set in a third state in a controlled manner. The control unit 114, if in the third state, may be configured to close all semiconductor switches 110, 122, 131 in the signal connection 162 so that the ignition current is flowing through the ignition unit 112.

The first node 104 of the circuit arrangement 102 may be coupled to an energy storage device 108, other than the main battery of the vehicle, such that the circuit arrangement 102 is also supplied with electrical energy by the energy storage device 108. The electrical energy provided by the energy storage device 108 can provide an ignition current through the ignition unit 112. The current through the signal connection 162 of the circuit arrangement 102 is controllable by the first semiconductor switch 110. Unless the vehicle is in an accident situation, the controlled first semiconductor switch 110 may prevent the ignition current from flowing through the signal connection 162 and/or through the ignition unit 112.

The energy storage device 108 may be configured as a capacitive electrical energy storage device. For example, the energy storage device 108 may comprise a capacitor 138, referred to as the storage capacitor 138, configured to capacitively store electrical energy. In an example, the energy storage device 108 does not comprise any other component for storing electrical energy. The storage capacitor 138 may be provided with multiple sub-components, such that the storage capacitor 138 is formed of a network comprising a plurality of (smaller) capacitors. The energy storage device 108 may comprise an internal electrical impedance, referred to as internal impedance 140. In simplified terms, the energy storage device 108 may be a series connection of the storage capacitor 138 and the internal impedance 140. In an example, the energy storage device 108 is configured to be coupled between the first and second nodes 104, 106 of the circuit arrangement 102.

The energy storage device 108, and in an example the associated storage capacitor 138, may be configured to store sufficient electrical energy such that the energy storage device 108 and/or the storage capacitor 138 may cause ignition current to flow through the ignition unit 112 if necessary, for example, in the event of an accident. It is desirable to monitor the electrical energy stored by energy storage device 108 and/or the health of energy storage device 108. By monitoring the energy storage device 108, it can be ensured that the energy storage device 108 is capable of providing ignition power to the ignition unit 112 at all times, and particularly if an accident situation occurs.

The ability of the energy storage device 108 to provide the ignition current may depend on the capacitance of the storage capacitor 138 and/or a resistance value of the internal impedance 140. In order to measure the capacitance of the storage capacitor 138 and/or to measure the resistance value of the internal impedance 140, a current, also referred to as the measurement current Id, is required to flow through the energy storage device 100. The measurement current Id can be caused via the circuit arrangement 102. The measurement current Id should be as small as possible to prevent unnecessary discharge of the storage capacitor 138. Furthermore, the measurement current Id should be smaller than the ignition current to prevent ignition of the pyrotechnic material of the ignition unit 112.

Against this background, a device 100 is proposed. An example of an embodiment of the device 100 is schematically illustrated in Figure 1.

The device 100 may be configured to be coupled to the circuit arrangement 102. The device 100 comprises a control unit 114. The control unit 114 is configured to be coupled to the first semiconductor switch 110 of the circuit arrangement 102. In an example, the control unit 114 may be coupled to the first semiconductor switch 110 via a signal connection 168. A driver circuit 156 may be integrated into the signal connection 168. The driver circuit 156 may form a component of the control unit 114 and/or a component of the device 100. At the first semiconductor switch 110, the signal connection 168 may be coupled to a gate terminal of the first semiconductor switch 110. Via the gate terminal of the first semiconductor switch 110 and the signal connection 168, the control unit 114 may control a measurement resistance of the first semiconductor switch 110. In an example, the control unit 114 may generate a control signal at the gate terminal of the first semiconductor switch 110, in particular also in cooperation with the driver circuit 156, such that the control unit 114 controls the measurement resistance of the first semiconductor switch 110 via the control signal. The first semiconductor switch 110 may comprise a source terminal and a drain terminal, wherein the first semiconductor switch 110 is integrated into the signal connection 162 via the source terminal and the drain terminal. The measurement resistance of the first semiconductor switch 110 may relate to an electrical resistance between the source terminal and the drain terminal.

The control unit 114 of the device 100 is configured to be set in a first state Z1. The first state Z1 may also be referred to as the monitoring state Z1. The control unit 114 is configured, if the control unit 114 is in the first state Z1, to control the first semiconductor switch 110 such that the first semiconductor switch 110 adjusts an electric current I1 through the first semiconductor switch 110 and the ignition unit 112 to a predefined current referred to as the measurement current Id, wherein the measurement current Id is between 1% and 40% of the ignition current, for example between 1% and 10% of the ignition current.

The measurement current Id forms the basis for performing a measurement to be able to determine the capacitance of the storage capacitor 138 and/or the resistance value of the internal impedance 140 of the energy storage device 108. The measurement current Id is predefined to be small enough that the measurement current Id does not cause ignition of the ignition unit 112, and in particular does not cause ignition of a pyrotechnic material of the ignition unit 112. The ignition of the ignition unit 112 may refer to the ignition of the pyrotechnic material of the ignition unit. Ignition will occur only if the current through the ignition unit 112 reaches the value of the ignition current or a greater value. If the current through the ignition unit 112 is less than the ignition current, no ignition of the ignition unit will occur. The measurement current Id can therefore be caused at any time by means of the control unit 114 of the device 100 without any risk in terms of the operation of a vehicle. The measurement current Id is also selected to be small enough that the measurement current Id causes a negligible small discharge of the storage capacitor 138.

In an example, the control unit 114 is configured such that a length of time during which the measurement current Id is caused using the control unit 114 is limited to a predefined maximum time. For example, the maximum time may be 10 ms, 5 ms or 2 ms. The predefined maximum time may also ensure that the small measurement current Id causes only a negligible discharge of the storage capacitor 138 when performing a measurement.

The first semiconductor switch 110 and the ignition unit 112 are connected in series and integrated into the signal connection 162 extending from the first node 104 to the second node 106. By controlling the first semiconductor switch 110, if the control unit 114 is in the first state Z1 such that the measurement current Id flows through the first semiconductor switch 110, the same measurement current Id will also flow through the ignition unit 112 due to the series connection. Through the first semiconductor switch 110, the control unit 114 can control the current through the ignition unit 112 and adjust it to the measurement current Id.

In addition to the first semiconductor switch 110 and the ignition unit 112, other components may be integrated into the signal connection 162 and/or connected in series with the first semiconductor switch 110 and the ignition unit 112. Even if these components are provided, the current through the ignition unit 112 can be controlled via the first semiconductor switch 110. The first semiconductor switch 110 may be controlled by the control unit 114.

In an example, the ignition unit 112 may be configured so that the ignition current is 2 A. In an example, the measurement current Id is between 10 mA and 400 mA. Therefore, the measurement current Id does not cause ignition of the ignition unit 112. The length of time while the measurement current Id is actually flowing through the ignition unit 112 may be limited to, for example, 1 ms. This effectively prevents the measurement current Id from flowing continuously for longer than 1 ms.

The circuit arrangement 102 may be the same circuit arrangement 102 that might be used to cause the ignition unit 112 to ignite in an accident situation. Thus, the circuit arrangement 102 may be reused, not only to ignite the ignition unit 112 in an accident situation, but also to provide the measurement current Id.

To ensure that the measurement current Id also flows through the energy storage device 108, the fifth semiconductor switch 134 may be set in the open state. In the open state, the fifth semiconductor switch 134 interrupts the signal connection 184. By changing the fifth semiconductor switch 134 to the open state, the measurement current Id can be prevented from being supplied from the (main) battery of a vehicle. Therefore, the energy storage device 108 remains the sole source of the measurement current Id, and the measurement current Id is therefore suitable for determining the capacitance of the storage capacitor 138 and/or the resistance will of the internal impedance 140.

The control unit 114 may be configured to be coupled to the fifth semiconductor switch 134 via a signal connection 178. A (further) driver circuit 160 may be integrated into the signal connection 178. A driver circuit, like driver circuit 160, may be formed by a charge driver. The driver circuit 160 may form a part of the device 100 and/or the control unit 114. The signal connection 178 may be coupled to a gate terminal of the fifth semiconductor switch 134. The control unit 114 may be configured to generate a control signal at the gate terminal of the fifth semiconductor switch. The control unit 114 may use the control signal to set the fifth semiconductor switch in the open state. In an example, if the control unit 114 is in the first state Z1, the control unit 114 is configured to control the fifth semiconductor switch 134 to change to the open state and/or remain in the open state.

When the control unit 114 is in the first state Z1, the control unit 114 can both, to cause the opening state of the fifth semiconductor switch 134 and to cause the measurement current Id to flow through the ignition unit 112.

In an example, the control unit 114 is configured such that if the control unit 114 is in the first state Z1, the control unit 114 controls the first semiconductor switch 110 such that the measurement current Id flows as a constant, electrical current through the first semiconductor switch 110 and the ignition unit 112, provided that the energy storage device 108 is coupled between the first node 104 and the second node 106 of the circuit arrangement 102.

Previously, the device 100 was explained as being configured to cause a desired measurement current Id to flow through the ignition unit 112 thanks to the associated control unit 114. Another need is to detect a voltage of the energy storage device 108 such that, based on the detected voltage, a determination of the capacitance of the storage capacitor 138 and/or a determination of the resistance value of the internal impedance 140 is enabled. The determined capacitance and/or the determined resistance value of the internal impedance can be used to infer the state of the energy storage device 108, in particular its healthy state.

In an example, the device 100 comprises a sensor unit 118. An input of the sensor unit 118, referred to as the sensor input 154, is configured to be coupled to the circuit arrangement 102. The sensor unit 118 is further configured to detect, via the sensor input 154, a voltage referred to as the detection voltage, which represents an electrical voltage of the energy storage device 108.

The sensor input 154 may be coupled to the first node 104 of the circuit arrangement 102, for example, via the signal connection 170. A capacitor 124 may be integrated into the signal connection 170, where the capacitor 124 is referred to as the decoupling capacitor 124. The decoupling capacitor 124 may be comprised by the device 100. Via the signal connection 170, the sensor unit 118 may measure the electrical detection voltage at the associated sensor input 154, which represents an electrical voltage at the node 104. In an example, the node 104 is coupled to the energy storage device 108 via the signal connection 172. As a result of the signal connection 170, the node 104 and the further signal connection 172, the sensor unit 118 may measure the detection voltage at the sensor input 154, which is and/or represents an electrical voltage of the energy storage device 108. In principle, it is possible that the signal connection 170 extends from the sensor input 154 of the sensor unit 118 to another location of the signal connection 162 of the circuit arrangement 102, so that the detection voltage detected in this case may also represent the electrical voltage of the energy storage device 108, because the first semiconductor switch 110, the ignition unit 112 and possible further components of the circuit arrangement 102 are connected in series and integrated into the signal connection 162. The decoupling capacitor 124 may be used for and/or provide the benefit of lowering a potential level of an electrical voltage at the node 104 relative to a potential level of the detection voltage at the sensor input 154. Therefore, low cost components may be used for the sensor unit 118 to accurately measure the (smaller) detection voltage.

In an example, the sensor unit 118 is configured to generate an output voltage Vout at an output 120 of the sensor unit 118 based on the detected detection voltage, such that the output voltage Vout may also represent the voltage of the energy storage device 108. The output of the sensor unit 118 may also be referred to as the sensor output 120. In an example, the sensor unit 118 may comprise an amplifier 126 coupled to the sensor input 154, wherein the amplifier 126 is configured to generate the output signal at the sensor output 120 based on the detected voltage. The amplifier 126 may be configured as a differential voltage signal amplifier. An input of the amplifier 126 may be coupled to the sensor input 154. A further input of the amplifier 126 may be configured such that a predefined reference voltage is applied to this further input of the amplifier 126. A voltage difference between the reference voltage and the detection voltage is amplified by the amplifier 126 according to a predefined gain factor, such that the voltage difference amplified by the gain factor forms the output voltage Vout at the sensor output 120. The gain factor of the amplifier 126 may be greater than one (1). In an example, the gain factor may be between 1.5 and 20. In an example, the voltage difference is linearly dependent on the detection voltage. As a result, the output voltage Vout is also linearly dependent on the detection voltage. Because the detection voltage can represent the electrical voltage of the energy storage device 108, it is analogously true for the output voltage Vout that the output voltage Vout can also represent the electrical voltage of the energy storage device 108.

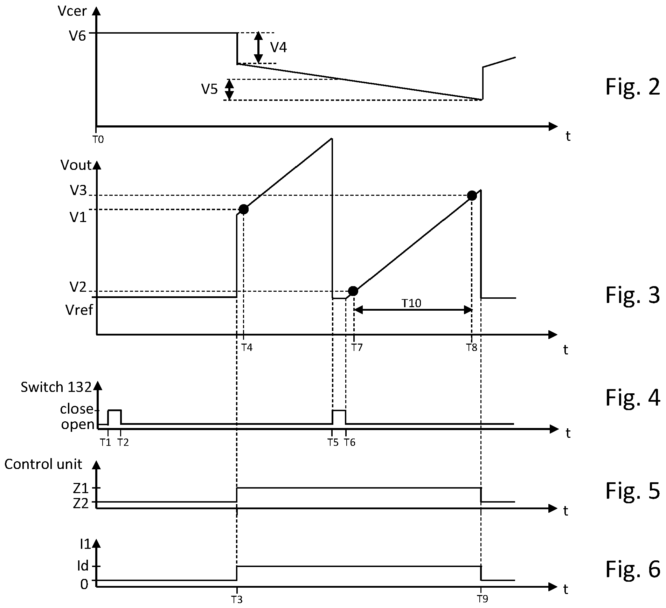

In each of Figures 2, 3, and 6, a signal waveform is shown schematically. In Figure 4, the switching state of the fourth semiconductor switch 132 is schematically shown. In Figure 5, the state of the control unit 114 is schematically shown as a state curve. The time specifications T0 to T10 in Figures 2-6 may be understood analogously to each other and/or may apply in an analogous manner.

The following explanations in connection with Figures 2-6 are not to be understood restrictively, but as explanations of a possible examples. The explanations may related to advantageous features, technical effects and or benefits.

In an example, the points in time T0 to T9 schematically shown in Figures 2 to 6 may be understood as successive points in time with a time interval between two successive points in time. The time intervals can in each case be individually predefined and/or deviate from each other.

As can be seen from the example of Figure 2, the voltage Vcer at the first node 104 of the circuit arrangement 102 at time T0 has the value of the voltage V6. In an example, the first node 104 is connected to the energy storage device 108 via the signal connection 172. The voltage Vcer at the first node 104 thus corresponds to the electrical voltage of the energy storage device 108. For simplicity, all voltages are referenced with respect to a common reference potential 142, 144, in particular ground potential.

As can be seen from the example of Figure 5, the control unit 114 is in a second state Z2 at time T0. The control unit 114 may be configured, if the control unit 114 is in the second state Z2, to control the first semiconductor switch 110 via the signal connection 168 such that the first semiconductor switch 110 is in an open state. As can be seen from Figure 6, the open state of the first semiconductor switch 110 causes no current and/or no measurement current Id to flow through the signal connection 162. The control unit 114 may further be configured, if the control unit 114 is in the second state Z2, to control the fifth semiconductor switch 134 via the signal connection 178 such that the fifth semiconductor switch 134 is in a closed state. The closed fifth semiconductor switch 134 ensures that the energy storage device 108 is (fully) charged by the main battery and/or another energy source of the vehicle.

As can be seen from the example of Figure 3, the output voltage Vout at the sensor output 120 at time T0 is at the voltage value Vref. This voltage value may also be referred to as the reference voltage Vref. In an example, the reference voltage Vref may be applied to one of the two inputs 152 of the amplifier 126. At time T0, it is assumed that an equilibrium state exists. The decoupling capacitor 124 may be charged such that the other input of the amplifier 126, which is coupled to the sensor input 154, also has at least substantially the reference voltage Vref applied to it. This relationship is particularly true if the amplifier comprises a gain of 1.

The sensor unit 118 may further comprise an electrical capacitor referred to as the feedback capacitor 128. The feedback capacitor 128 may be coupled between the sensor input 154 and the sensor output 120. In an example, the capacitance of the feedback capacitor 128 is between 5% and 66% of the capacitance of the decoupling capacitor 124. The gain of the amplifier 126 may be defined by the capacitance of the two capacitors 124, 128. In an example, the gain factor of the amplifier 126 is defined by the ratio of the capacitance of the feedback capacitor 124 to the capacitance of the feedback capacitor 128. By selecting the capacitances of the two capacitors 124, 128, the gain factor of the amplifier 126 may be set and/or predefined in the range between 1.5 and 20, for example.

The sensor unit 118 may comprise a semiconductor switch 132, referred to as the fourth semiconductor switch 132. The fourth semiconductor switch 132 may be formed, for example, by a MOS transistor, such as an NMOS transistor or PMOS transistor. The fourth semiconductor switch 132 may be coupled between the sensor input 154 and the sensor output 120. The control unit 114 may be coupled to the fourth semiconductor switch 132 via a signal connection 176. The control unit 114 may control the fourth semiconductor switch 132 via the signal connection 176. The control unit 114 may set the fourth semiconductor switch 132 in either an open state or a closed state. In the open state, the sensor input 154 and the signal output 120 are not connected by the fourth semiconductor switch 132. In the closed state, the sensor input 154 and the sensor output 120 are connected through the fourth semiconductor switch 132.

In the example shown in Figure 4, a state diagram of the fourth semiconductor switch 132 is schematically shown. At time T0, the fourth semiconductor switch 132 is in the open state. The control unit 114 may control the fourth semiconductor switch 132 so that the fourth semiconductor switch 132 is in the open state in the period between times T0 and T1, in the closed state in the period between times T1 and T2, in the open state in the period between times T2 and T5, in the closed state in the period between times T5 and T6, and in the open state from time T6. If the fourth semiconductor switch 132 is in the closed state, the output voltage Vout at the sensor output 120 is (re-)set to the reference voltage Vref. The (re-)setting of the output voltage Vout may be controlled by the control unit 114. (Re-)setting the output voltage Vout has the advantage of adjusting the output voltage Vout into a measurable range for an analog-to-digital converter of the control unit 114. The control unit 114 may comprise such an analog-to-digital converter to measure the output voltage Vout forwarded to the control unit via the signal connection 174.

In an example, the control unit 114 is coupled to the sensor output 120 of the sensor unit 118. In an example, a signal connection 174 may extend from the sensor output 120 to the control unit 114. At time T0, the control unit 114 is in the second state Z2. At time T0, the output voltage Vout at sensor output 120 is the predefined reference voltage Vref. To prevent possible deviations from the predefined reference voltage Vref, the fourth semiconductor switch 132 may be closed in the period between time T1 and T2. In an example, the control unit 114 may control the fourth semiconductor switch 132 to the closed state at the time T1 and back to the open state at the time T2. The control unit 114 is in the second state Z2 during the period between the time T0 and a time T3. The time T3 may also be referred to as the switching time T3. As a result, the control unit 114 may control the fourth semiconductor switch 132 to the closed state in the period between time T1 and time T2 while the control unit 114 is in the second state Z2. The control unit 114 may be configured, if the control unit 114 is in the second state Z2, to control the first semiconductor switch 110 to the open state. Due to the open state of the first semiconductor switch 110, no current flows through the signal connection 162 during the period between the two times T0, T3, as also schematically shown in Figure 6. It is assumed that the energy storage device 108, and in particular the associated storage capacitor 138, is fully charged at the time T3, and may also during the period between times T0, T3, so that an electrical voltage V6 is applied to the first node 104 via the signal connection 172.

The control unit 114 may be configured such that the control unit 114 may change from the first state Z1 of the control unit 114 to the second state Z2 of the control unit 114, and vice versa. The control unit 114 may be configured to independently perform the change from the first state Z1 to the second state Z2. The control unit 114 may also be configured to autonomously determine the timing of the change from the first state Z1 to the second state Z2. In another example, the device 100 may comprise a control input port 150 to receive a control signal. The control input port 150 may be coupled to the control unit 114 via a signal connection 186. A state control signal may be communicated to the control unit 114 via control input port 150 and/or the signal connection 186 to the control unit 114. The state control signal may represent an instruction to change from the first state Z1 to the second state Z2, or vice versa, and/or a time to change state. For example, the state control signal may represent an instruction to change from the second state Z2 to the first state Z1 and an instruction to change state at the switching time T3.

The control unit 114 may change from the second state Z2 to the first state Z1 at the switching time T3. A corresponding state change is schematically shown in Figure 5. The control unit 114 may perform the state change automatically and/or based on a receiving state control signal. By changing to the first state Z 1, the control unit 114 performs control of the first semiconductor switch 110 such that the first semiconductor switch 110 is neither in the open state nor in the closed state. In an example, if the control unit 114 is in the first state Z1, the first semiconductor switch 110 is controlled (by the control unit 114) to a state, also referred to as the resistance state, which is between the open state and the closed state of the first semiconductor switch 110. The control unit 114, if the control unit 114 is in the first state Z1, controls the first semiconductor switch 110 so that the first semiconductor switch 110 may be in the resistance state and/or an electric current I1 through the first semiconductor switch 110 and the ignition unit 112 is adjusted to be equal to the predefined measurement current Id. In the resistance state of the first semiconductor switch 110, the measurement current Id flows through both the first semiconductor switch 110 and the ignition unit 112. In Figure 6, the time course of the electric current I1 is shown schematically. As can be seen schematically from Figure 6, the electric current I1 changes from 0 A to the predefined measurement current Id at the switching time T3. The measurement current Id can be then be constant. The measurement current Id is between 1% and 40% of the ignition current. In an example, the measurement current Id can be 400 mA. In an example, the ignition current can be 2 A. Due to the change of state at the switching time T3 and the resulting measurement current Id, the electrical voltage of the energy storage device 108 and/or the electrical voltage at the first node 104 decreases. In an example, the electrical voltage of the energy storage device 108 and/or the first node 104 decreases by the voltage value V4 at the switching time T3. The voltage drop may be caused by the internal impedance 140, which may represent an internal impedance 140 of an internal storage resistor. The voltage value V4 depends on the internal impedance 140 . The change in the electrical voltage at the first node 104 (at time T3) causes a change in the output voltage Vout at the sensor output 120 of the sensor unit 118. As can be seen schematically from Figure 3, the output voltage Vout at the sensor output 120 increases to the first value V1 of the output voltage Vout at a time T4 immediately following the switching time T3. The period between the switching time T3 and the time T4 may be very small. Therefore, it may be assumed that the first value V1 of the output voltage Vout corresponds at least substantially to the output voltage Vout at the switching time T3.

The control unit 114 may be configured, if the control unit 114 is in the first state Z1, such that the control unit 114 detects the first value V1 of the output voltage Vout at a first time T4 referred to as the first sample time T4. The control unit 114 may further be configured such that the control unit 114 determines an electrical impedance of the energy storage device 108 based on the first value V1 of the output voltage Vout. In an example, the control unit 114 may determine the electrical impedance of the energy storage device 108 based on the first value V1 of the output voltage Vout, the predefined reference voltage Vref, the predefined gain factor (of the amplifier 126), and the predefined measurement current Id. The control unit 114 may be configured to calculate the electrical impedance of the energy storage device 108 based on the following mathematical formula:

$$\text{electrical impedance} = (\text{first value V1} - \text{reference voltage Vref}) / (\text{gain factor} * \text{measurement current Id}).$$

The electrical impedance of the energy storage device 108 may be the electrical impedance of the storage resistor. Based on the electrical impedance of the energy storage device 108, a qualitative message can be generated about the state of health of the energy storage device 108. The determined, electrical impedance, in particular in relation to a predefined reference impedance, can represent the state of health of the energy storage device 108. If the determined, electrical impedance of the energy storage device deviates very large from the reference impedance, the large deviation indicates a poor state of health. If the deviation of the determined, electrical impedance is only very small in relation to the reference impedance, this small deviation indicates a good state of health of the energy storage device.

Provided that only the electrical impedance of the energy storage device 108 is used to determine a state of health, the control unit 114 can change back to the second state Z2 directly following the time T4, but this situation is not shown in Figures 2-6, even though it might represent a possible flow for checking the health of the energy storage device 108. The period between times T3 and T4 while the control unit 114 would be in the first state Z1 is very short, so that at most there is very little electrical discharge of the energy storage device 108. However, as noted above, this sequence of events is not illustrated in Figures 2-6.

The control unit 114 may be configured to close the fourth semiconductor switch 132 during the time period between the time T5 and time T6. The period between the times T4 and T5 may be predefined. The control unit may further be configured to reopen the fourth semiconductor switch 132 at the time T6. The period between time T5 and time T6 may be predefined. Closing the fourth semiconductor switch 132 during the period T5 to T6 causes the output voltage Vout to be reset to the reference voltage Vref at the time T6. Because the measurement current Id continues to flow through the signal connection 162, the output voltage Vout at the sensor output 120 will rise again from time T6. A corresponding signal waveform can be seen schematically from Figure 3.

As can be seen schematically from Figure 3, the output voltage Vout at the sensor output 120 rises to the second value V2 of the output voltage Vout at time T7 which may follow immediately or only slightly delayed after the time T6. In an example, a time interval between time T6 and time T7 may be referred to as the second delay time. In an example, the second delay time is very small. In an example, the second delay time is smaller than a predefined time, such as 0.01 ms. Therefore, in an example, it may be assumed that the second value V2 of the output voltage Vout is at least substantially equal to the output voltage Vout, for example the reference voltage, at time T6.

The control unit 114 may be configured, if the control unit 114 is in the first state Z 1, such that the control unit 114 detects the second value V2 of the output voltage Vout at a second time T7, referred to as the second sample time T7. Further, if the control unit 114 is in the first state Z1, the control unit 114 may be configured to detect a third value V3 of the output voltage Vout at a third time T8 referred to as the third sample time T8. The period T10 between the second sample time T7 and the third sample time T8 may be predefined, such as by a second interval in the range between 0.2 ms and 0.6 ms. In an example, the third sample time T8 is in a predefined time interval, referred to as the lead time (T8 to T9), before the time T9 at which the second opening time (T6 to T9) ends. For example, the lead time may be less than 0.1 ms. The control unit 114 may be configured to change to the second state Z2 after the second opening time (T6 to T9) ends.

During the period between time T6 and T9, the constant measuring current Id flows through the energy storage device 108 and the signal connection 162. the energy storage device 108 is discharged by the measuring current at a constant rate (although only very slightly), which leads to a reduction in the voltage Vcer at the node 104 and/or a reduction in the voltage at the sensor input 154. The decrease occurs with a constant slope (falling). As a result, the output voltage Vout increases with a constant slope in the period from T6 to T7. The slope depends on both the measuring current Id and the capacitance of the storage capacitor 138. Because the measuring current Id is assumed to be constant, the slope of the output voltage Vout may be assumed to be essentially dependent on the capacitance of the storage capacitor 138.

The control unit 114 may be configured such that the control unit 114 determines an electrical capacitance of the energy storage device 108 based on the second and third values V2, V3 of the output voltage Vout. In an example, the control unit 114 may determine the electrical capacitance of the energy storage device 108 based on the second value V2 of the output voltage Vout, the third value V3 of the output voltage Vout, the predefined gain factor (of the amplifier 126), the second sample time T7, the third sample time T8, and the predefined measurement current Id. The control unit 114 may be configured to calculate the electrical capacitance of the energy storage device 108 based on the following mathematical formula:

$$\text{electrical capacitance} = \text{measurement current Id} * \text{gain factor} * (\text{third sample time T8} - \text{second sample time T7}) / (\text{third value V3} - \text{second value V2}).$$

The electrical capacitance of the energy storage device 108 may be the electrical capacitance of the storage capacitor 138. Based on the electrical capacitance of the energy storage device 108, a qualitative message can be generated as to whether sufficient electrical energy is stored by energy storage device 108 to ensure ignition of ignition unit 112, such as in an accident situation. The determined, electrical capacitance of the energy storage device 108 can be compared to a predefined, minimum capacitance, also referred to as minimum capacitance. If the determined, electrical

EP 4 484 226 A1

capacitance of the energy storage device 108 is greater than the minimum capacitance, a qualitative message can be generated that the energy stored by the energy storage device 108 is able to ignite the ignition unit 112. On the other hand, if the determined, electrical capacitance of the energy storage device 108 is smaller than the minimum capacitance, there is a risk that the ignition unit 112 cannot be ignited by the energy storage device 108. In this case, the control unit 112 may determine an error of the energy storage device 108 and/or generate an error signal representing the error. The control unit 114 may be configured to send the error signal via an interface of the device 100, particularly to a supervisory control unit of the vehicle.

The control unit 114 may be configured such that the control unit 114 changes from the first state Z1 to the second state Z2 at a time T9. The time period between the time T8 and the time T9 may be very small, such as less than 1 ms, less than 0.5 ms or less than 0.1 ms. The time period between the switching time T3 and the time T9 may be predefined. In an example, the time period between the switching time point T3 and the time point T9 is less than 2 ms, less than 1 ms, or less than 0.5 ms. The smaller said time period, the less electrical energy is drawn from the energy storage device 108 to perform the previously explained measurements. In an example, the time period between the switching time T3 and the time T9 is selected such that the energy stored by the energy storage device is sufficient to ensure ignition of the ignition unit 112 even after the time T9.

In an example, if the control unit 114 is in the second state Z2, the control unit 114 is configured to control the fourth semiconductor switch 132 to close the fourth semiconductor switch 132 before the first sample time T4 during a predefined time referred to as the first closing time. The first closing time may be defined by the period between time T1 and time T2. The closing time offers the advantage that the output voltage Vout at sensor output 120 is set to the reference voltage Vref. At the switching time T3, which is before the time T4, the control unit 114 may change back to the first state Z1.

The control unit 114 may be configured, if in the first state Z1, to control the fourth semiconductor switch 132 to open the fourth semiconductor switch 132 during a time referred to as the first opening time. The first opening time may be in the period between the time T2 and the time T5. The first opening time may immediately follow the first closing time (T1 to T2). If the fourth semiconductor switch 132 is in the open state during the first opening time, the amplifier 126 may amplify a differential voltage between the associated inputs according to an amplification factor determined by the two capacitors 124, 128. The times T3, T4 are between the time T2 and the time T5.

In an example, the control unit 114 is configured to change from the second state Z2 to the first state Z1 during the first opening time (T2 to T5). The control unit 114 may be configured to perform the state change at the switching time T3. The state change causes the measurement current Id to flow through the first semiconductor switch 110 and the ignition unit 112. The measurement current Id may be used to allow the previously explained values V1, V2, V3 of the output voltage Vout at the sensor output 120 to be measured. The first sample time T4 follows the switching time T3 with a first delay time. The first delay time may be a period between the times T3 and T4. In an example, the first delay time is less than a predefined time, like less than 0.1 ms.

In an example, the control unit 114 is configured to control the first semiconductor switch 110 during the period between the times T3, T4 and while the control unit 114 is in the first state Z1 such that the first semiconductor switch 110 adjusts the current I1 to the measurement current Id through the first semiconductor switch 110 and the ignition unit 112. To adjust current I1 to be the measurement current Id, the control unit 114 may control the measurement resistance of the first semiconductor switch 110.

In an example, if the control unit 114 is in the first state Z1, the control unit 114 is configured such that the control unit 114 controls the fourth semiconductor switch 132 to close the fourth semiconductor switch 132 during a predefined time period referred to as the second closing time. The second closing time is the period between the time T5 and the time T6. Thus, the second closing time immediately follows the first opening time (T2 to T5). Further, if the control unit 114 is in the first state Z 1, the control unit 114 may be configured such that the control unit 114 controls the fourth semiconductor switch 132 to open the fourth semiconductor switch 132 during a predefined time period referred to as the second opening time. In an example, the second opening time is the period between the time T6 and the time T9. Thus, the second opening time immediately follows the second closing time (T5 to T6).

In an example, the circuit arrangement 102 may comprise another semiconductor switch 122, referred to as the second semiconductor switch 122. In an example, the second semiconductor switch 122 may be formed by a MOS transistor, such as a PMOS transistor or a NMOS transistor. The first semiconductor switch 110, the ignition unit 112, and the second semiconductor switch 122 may be connected in series. The second semiconductor switch 122 may also be integrated into the signal connection 162. The ignition unit 112 may be disposed in the series connection between the first semiconductor switch 110 and the second semiconductor switch 122. The control unit 114 may be configured to be coupled to the second semiconductor switch 122. In an example, if the control unit 114 is in the first state Z1, the control unit 114 is configured to control both the first semiconductor switch 110 and the second semiconductor switch 122 such that both the first semiconductor switch 110 and the second semiconductor switch 122 adjust the electric current I1 through the first and second semiconductor switches 110, 122 and the ignition unit 112 to the measurement current Id. Thus, the measurement current Id can be adjusted by both semiconductor switches 110, 122 if the two semiconductor switches 107, 122 are controlled accordingly by the control unit 114. The preceding explanations, preferred features, technical effects and advantages as explained in connection with the first semiconductor switch 110 may apply in a corresponding manner to the second semiconductor switch 122 (and vice versa) and/or both semiconductor switches 110, 122 connected in series.

In an example, the control unit 114 may be coupled to the second semiconductor switch 122 via a signal connection 166. A driver circuit 158 may be integrated into the signal connection 166. The driver circuit 158 may form a component of the control unit 114 and/or a component of the device 100. At the second semiconductor switch 122, the signal connection 166 may be coupled to a gate terminal of the second semiconductor switch 122. Via the gate terminal of the second semiconductor switch 122 and the signal connection 166, the control unit 114 may control a measurement resistance of the second semiconductor switch 122. In an example, the control unit 114 may generate a control signal at the gate terminal of the second semiconductor switch 122, in particular also in cooperation with the driver circuit 158, such that the control unit 114 controls the measurement resistance of the second semiconductor switch 122 via the control signal. The second semiconductor switch 122 may comprise a source terminal and a drain terminal, wherein the second semiconductor switch 122 is integrated into the signal connection 162 via the two terminals. The measurement resistance of the second semiconductor switch 122 may relate to an electrical resistance between the source terminal and the drain terminal. The control unit 114 may be configured, if the control unit is in the first state Z1, to control the measurement resistance of the first semiconductor switch 110 and/or the measurement resistance of the second semiconductor switch 122 such that a current through the ignition unit 112, and may be also through the first semiconductor switch 110 and/or the second semiconductor switch 122, if the current is present, is set to the predefined measurement current Id. In an example, the first semiconductor switch 110, the ignition unit 112, and the second semiconductor switch 122 are connected in series and integrated into the signal connection 162 extending from the first node 104 to the second node 106. Therefore, the control unit 114 may also be configured, if the control unit 114 is in the first state Z1, to control the measurement resistance of the first semiconductor switch 110 and/or the measurement resistance of the second semiconductor switch 122 such that a current through the signal connection 162, if present, is adjusted to be the predefined measurement current Id.

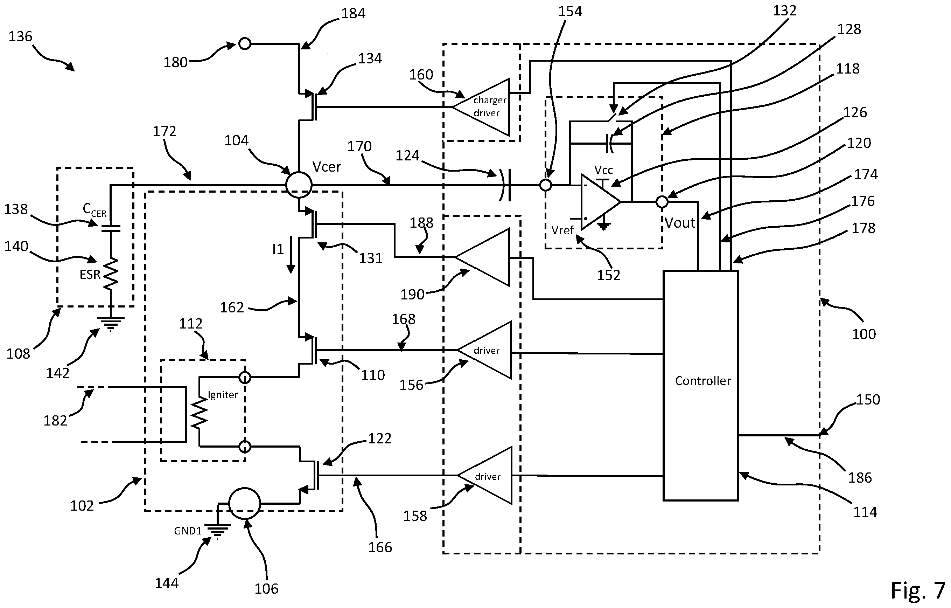

In Figure 7, an example of a further embodiment of the device 100 is schematically shown. For the device of Figure 7, reference is made to the preceding explanations, preferred features, technical effects and advantages in an analogous manner as they are explained for the device 100 on Figure 1 and for example in connection with Figures 2 to 6.

The circuit arrangement 102 may comprise another semiconductor switch 131, referred to as the third semiconductor switch 131. The third semiconductor switch 131 may be formed by, for example, a MOS transistor, such as an NMOS transistor or a PMOS transistor. The third semiconductor switch 131, the first semiconductor switch 110, the ignition unit 112, and the second semiconductor switch 122 may be connected in series. The third semiconductor switch 131 may also be integrated into the signal connection 162, for example between the first node 104 and the first semiconductor switch 110. The control unit 114 may be configured such that the control unit 114 may be coupled to the third semiconductor switch 131.

In an example, the control unit 114 may be coupled to the third semiconductor switch 131 via a signal connection 188. A driver circuit 190 may be integrated into the signal connection 188. The driver circuit 190 may form a component of the control unit 114 and/or a component of the device 100. At the third semiconductor switch 131, the signal connection 188 may be coupled to a gate terminal of the third semiconductor switch 131. Via the gate terminal of the third semiconductor switch 131 and the signal connection 188, the control unit 114 may open or close the third semiconductor switch in a controlled manner. In an example, the control unit 114 may generate a control signal at the gate terminal of the third semiconductor switch 131, in particular also in cooperation with the driver circuit 190, so that the control unit 114 controls the third semiconductor switch 131 via the control signal. The third semiconductor switch 131 may comprise a source terminal and a drain terminal, wherein the third semiconductor switch 131 is integrated into the signal connection 162 via the two terminals.

The control unit 114 may be configured, if the control unit 114 is in the first state Z1, to close the third semiconductor switch 131. Further, if the control unit 114 is in the second state Z2, the control unit 114 may be configured to open the third semiconductor switch 131.

Referring to Figures 1 and 7, respectively, an example of an embodiment of a system 136 is schematically illustrated. The system 136 comprises the device 100. The device 100 may be configured in accordance with the embodiment of Figure 1 in an example, or in accordance with an embodiment of Figure 7 in another example. Further embodiments and/or preferred features of the device 100 will be apparent from the preceding discussion. The system 136 further comprises the circuit arrangement 102. The circuit arrangement 102 extends from the first node 104 to the second node 106. The circuit arrangement 102 comprises at least the first semiconductor switch 110 and the ignition unit 112. The ignition unit 112 is configured such that the ignition unit 112 ignites when the ignition current that can flow through the ignition unit 112 is reached. The control unit 114 of the device 100 is coupled to the first semiconductor switch 110.

The system 136 may further comprise the energy storage device 108. The energy storage device 108 may be coupled to the first node 104. As an effect, the energy storage device 108 may be coupled to the circuit arrangement 102 via the first node 104. The sensor unit 118 of the device 100 may also be coupled to the first node 104.

For the device 100, reference is made to the preceding explanations, preferred features, technical effects, and advantages in an analogous manner as previously explained for the device 100 in connection with Figures 1-7.

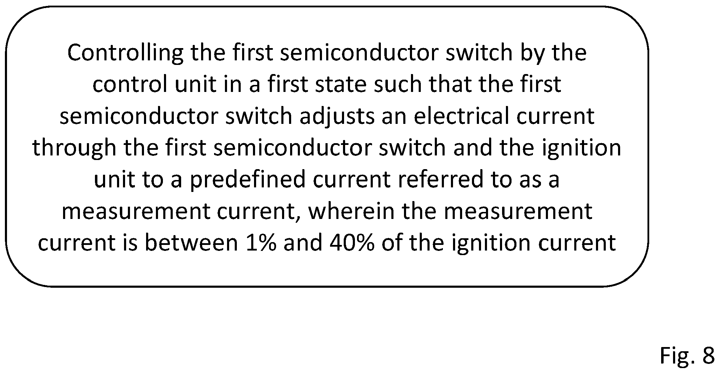

In Figure 8, an example of a method is schematically illustrated. The method may serve for the device 100 and/or for the system 136. The method comprises the step of: Controlling the first semiconductor switch 110 by the control unit 114 in a first state such that the first semiconductor switch 110 adjusts an electrical current I1 through the first semiconductor switch 110 and the ignition unit 112 to a predefined current referred to as a measurement current Id, wherein the measurement current Id is between 1% and 40% of the ignition current.

For the method, reference is made to the preceding explanations, preferred features, technical effects, and advantages in an analogous manner as previously explained for the device 100 and/or the system 136.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

**Claims**

1. A device for coupling to a circuit arrangement, which extends from a first node to a second node, wherein an energy storage device is coupled to the first node, the circuit arrangement comprising a first, controllable semiconductor switch and a unit, referred to as an ignition unit, the first semiconductor switch and the ignition unit being connected in series, the ignition unit being configured to ignite upon reaching a predefined current flowing through the ignition units, referred to as an ignition current; and

   wherein the device comprises a control unit configured to be coupled to the first semiconductor switch, and wherein, in a first state, the control unit is configured to control the first semiconductor switch such that the first semiconductor switch adjusts an electrical current through the first semiconductor switch and the ignition unit to a predefined current referred to as a measurement current, wherein the measurement current is between 1% and 40% of the ignition current.

2. The device according to the preceding claim,

   wherein the device comprises a sensor unit,
   wherein an input of the sensor unit, referred to as a sensor input, is configured to be coupled to the circuit arrangement and to detect a voltage, referred to as a detection voltage, representing an electrical voltage of the energy storage device,
   wherein the sensor unit is configured to generate an output voltage at an output of the sensor unit, referred to as sensor output, based on the detection voltage such that the output voltage also represents the voltage of the energy storage device, and
   wherein the control unit is coupled to the sensor output and configured, in the first state, to detect a first value of the output voltage at a first time, referred to as the first sampling time, and to detect a second value of the output voltage at a second time, referred to as the second sampling time.

3. The device according to the preceding claim, wherein the control unit is configured to determine an electrical capacitance and/or an internal electrical impedance of the energy storage device based on the measured values.

4. The device according to any of the preceding claims, wherein the circuit arrangement further comprises a second semiconductor switch, wherein the first semiconductor switch, the ignition unit, and the second semiconductor switch are connected in series, wherein the control unit is configured to be further coupled to the second semiconductor switch and wherein, in the first state, the control unit is configured to control the first and second semiconductor switches such that the first and second semiconductor switches adjust an electrical current through the first semiconductor switch, the ignition unit, and the second semiconductor switch to the predefined measurement current.

5. The device according to any of the preceding claims, if also depending on claim 2, wherein the sensor input of the sensor unit is configured to be coupled to the first node of the circuit arrangement.

6. The device according to any of the preceding claims, if also depending on claim 2, wherein the device comprises an electrical capacitor referred to as a decoupling capacitor, and wherein the device is configured to couple the sensor input of the sensor unit to the circuit arrangement via the decoupling capacitor.

7. The device according to the preceding claim, wherein the sensor unit comprises an amplifier coupled between the sensor input and the sensor output.

8. The device according to the preceding claim, wherein the sensor unit comprises an electrical capacitor, referred to as a feedback capacitor, coupled between the sensor input of the sensor unit and the sensor output of the sensor unit, wherein a capacitance of the feedback capacitor is between 5% and 66% of a capacitance of the decoupling capacitor.

9. The device according to any of the preceding claims, the control unit is configured to change from a first state of the control unit to a second state of the control unit, and vice versa.

10. The device according to any of the preceding claims, wherein the circuit arrangement further comprises a third semiconductor switch, wherein the third semiconductor switch, the first semiconductor switch, the ignition unit, and the second semiconductor switch are connected in series, wherein the control unit is further configured to be coupled to the third semiconductor switch, wherein the control unit is configured to close the third semiconductor switch in the first state, and wherein the control unit is configured to open the third semiconductor switch in the second state.

11. The device according to any of the preceding claims, if also depending on claim 9 and any of claims 6 or 7,

   wherein the sensor unit comprises a fourth semiconductor switch coupled between the sensor input of the sensor unit and the sensor output of the sensor unit,
   wherein the control unit is further coupled to the fourth semiconductor switch,
   wherein the control unit is configured, in the second state, to control the fourth semiconductor switch such that the fourth semiconductor switch is closed prior to the first sampling time and during a predefined time, referred to as the first closing time,
   wherein the control unit is configured to control the fourth semiconductor switch so that the fourth semiconductor switch is opened during a time referred to as the first opening time and directly following the first closing time,
   wherein the control unit is configured to change to the first state during the first opening time at a time referred to as the first switch time, and wherein the first sampling time follows the first switch time at a time interval of less than a predefined time, referred to as the first delay time.

12. The device according to any of the preceding claims,

   wherein the control unit, in the first state, is configured to control the fourth semiconductor switch to be closed during a predefined time referred to as the second closing time directly following the first opening time,
   wherein the control unit is configured in the first state to control the fourth semiconductor switch so that the fourth semiconductor switch is opened during a predefined time referred to as the second opening time and directly following the second closing time, and
   wherein the second sampling time follows a start of the second opening time at a time interval of less than a predefined time referred to as the second delay time.

13. The device according to any of the preceding claims,

   wherein the control unit is configured to detect a third value of the output voltage in the first state of the control unit at a third time referred to as the third sampling time,
   wherein the third sampling time is at a time interval of less than a predefined time, referred to as a lead time, before an end of the second opening time.

14. A system, comprising:

   the device according to any of the preceding claims,
   the circuit arrangement, and
   the energy storage device,
   wherein the circuit arrangement extending from the first node to the second node,
   wherein the energy storage device being coupled to the first node,
   wherein the circuit arrangement comprises the first controllable semiconductor switch and the ignition unit,
   wherein the first semiconductor switch and the ignition unit are coupled in series,
   wherein the ignition unit is configured to ignite upon reaching a predefined current flowing through the ignition unit, referred to as an ignition current, and
   wherein the control unit of the device is coupled to the first semiconductor switch.

15. A method for a device that can be coupled to a circuit arrangement extending from a first node to a second node, wherein an energy storage device is coupled to the first node, wherein the circuit arrangement comprises a first controllable semiconductor switch and a unit referred to as an ignition unit, wherein the first semiconductor switch and the ignition unit are connected in series, wherein the ignition unit is configured to ignite upon reaching a predefined current flowing through the ignition unit, referred to as ignition current, and wherein the device comprises a control unit configured to be coupled to the first semiconductor switch, and wherein the method comprises the step of:

   a) Controlling the first semiconductor switch by the control unit in a first state such that the first semiconductor switch adjusts an electrical current through the first semiconductor switch and the ignition unit to a predefined current referred to as a measurement current, wherein the measurement current is between 1% and 40% of the ignition current.

Fig. 1

Vcer

V6

V4

V5

T0

t

Fig. 2

Vout

V3

V1

V2

Vref

T4   T7   T10   T8

t

Fig. 3

Switch 132

close
open

T1 T2   T5 T6

t

Fig. 4

Control unit

Z1
Z2

t

Fig. 5

I1

Id

0

T3   T9

t

Fig. 6

Fig. 7

Controlling the first semiconductor switch by the control unit in a first state such that the first semiconductor switch adjusts an electrical current through the first semiconductor switch and the ignition unit to a predefined current referred to as a measurement current, wherein the measurement current is between 1% and 40% of the ignition current

Fig. 8

**EUROPEAN SEARCH REPORT**

Application Number

EP 23 30 6078

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/225924 A1 (SIBRAI ANDREAS [AT]) 13 October 2005 (2005-10-13) | 1,4,7-15 | INV. B60R21/017 |
| Y | * paragraphs [0046] - [0050]; figures 1-3 * | 2,3,5,6 | H02J7/34 |
| Y | US 2002/180268 A1 (MATTES BERNHARD [DE]) 5 December 2002 (2002-12-05) * paragraphs [0014] - [0016]; figure * | 2,3,5,6 | |
| A | US 5 293 153 A (ROCHETTE JEFFREY R [US] ET AL) 8 March 1994 (1994-03-08) * column 1, line 7 - column 2, line 64; figure 1 * | 1-15 | |
| A | US 5 957 988 A (OSAJDA MARC [FR] ET AL) 28 September 1999 (1999-09-28) * column 1, line 6 - column 4, line 22; figures * | 1-15 | |
| A | US 2009/160459 A1 (DE LANGEN KLAAS-JAN [NL] ET AL) 25 June 2009 (2009-06-25) * paragraphs [0001] - [0013]; figures * | 1,2 | |

TECHNICAL FIELDS SEARCHED (IPC)

B60R
H02J
G01R

The present search report has been drawn up for all claims

| Place of search | Date of completion of the search | Examiner |
|---|---|---|
| The Hague | 13 December 2023 | Daehnhardt, Andreas |

EPO FORM 1503 03.82 (P04C01)

## ANNEX TO THE EUROPEAN SEARCH REPORT
## ON EUROPEAN PATENT APPLICATION NO.

EP 23 30 6078

This annex lists the patent family members relating to the patent documents cited in the above-mentioned European search report.
The members are as contained in the European Patent Office EDP file on
The European Patent Office is in no way liable for these particulars which are merely given for the purpose of information.

13-12-2023

| Patent document cited in search report | | | Publication date | Patent family member(s) | | Publication date |
|---|---|---|---|---|---|---|
| US 2005225924 | A1 | | 13-10-2005 | EP 1582417 | A1 | 05-10-2005 |
| | | | | US 2005225924 | A1 | 13-10-2005 |
| US 2002180268 | A1 | | 05-12-2002 | AU 775379 | B2 | 29-07-2004 |
| | | | | DE 10027007 | A1 | 06-12-2001 |
| | | | | EP 1204544 | A1 | 15-05-2002 |
| | | | | JP 2003534970 | A | 25-11-2003 |
| | | | | US 2002180268 | A1 | 05-12-2002 |
| | | | | WO 0192066 | A1 | 06-12-2001 |
| US 5293153 | A | | 08-03-1994 | AT E139496 | T1 | 15-07-1996 |
| | | | | AU 1752692 | A | 17-11-1992 |
| | | | | DE 69211638 | T2 | 23-01-1997 |
| | | | | EP 0535207 | A1 | 07-04-1993 |
| | | | | JP H0775961 | B2 | 16-08-1995 |
| | | | | JP H05507047 | A | 14-10-1993 |
| | | | | US 5293153 | A | 08-03-1994 |
| | | | | WO 9218351 | A1 | 29-10-1992 |
| US 5957988 | A | | 28-09-1999 | CN 1181732 | A | 13-05-1998 |
| | | | | DE 69704006 | T2 | 19-07-2001 |
| | | | | EP 0819071 | A1 | 21-01-1998 |
| | | | | FR 2744862 | A1 | 14-08-1997 |
| | | | | JP H11504704 | A | 27-04-1999 |
| | | | | KR 19980703894 | A | 05-12-1998 |
| | | | | US 5957988 | A | 28-09-1999 |
| | | | | WO 9729932 | A1 | 21-08-1997 |
| US 2009160459 | A1 | | 25-06-2009 | CN 101091118 | A | 19-12-2007 |
| | | | | EP 1807709 | A1 | 18-07-2007 |
| | | | | JP 2008518227 | A | 29-05-2008 |
| | | | | KR 20070084590 | A | 24-08-2007 |
| | | | | TW 200624826 | A | 16-07-2006 |
| | | | | US 2009160459 | A1 | 25-06-2009 |
| | | | | WO 2006046218 | A1 | 04-05-2006 |

EPO FORM P0459

For more details about this annex : see Official Journal of the European Patent Office, No. 12/82